(19) Europäisches Patentamt / European Patent Office / Office européen des brevets

(11) **EP 2 670 049 A1**

(12) **EUROPEAN PATENT APPLICATION**

(43) Date of publication:
**04.12.2013 Bulletin 2013/49**

(51) Int Cl.:
**H03F 3/24** (2006.01)
**H03F 1/56** (2006.01)
**H03G 3/30** (2006.01)
**H03F 3/189** (2006.01)
**H04B 1/04** (2006.01)

(21) Application number: **12170263.3**

(22) Date of filing: **31.05.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **BlackBerry Limited**
**Waterloo, ON N2K 0A7 (CA)**

(72) Inventors:
• **Shaw, Dennis Keith**
  **Flower Mound, Texas, 75022 (US)**

• **Madabusi Srinivasan, Prasad Venkatesh**
  **Irving, Texas, 75039 (US)**

(74) Representative: **Bryn-Jacobsen, Caelia et al**
**Kilburn & Strode LLP**
**Electronics**
**20 Red Lion Street**
**London WC1R 4PJ (GB)**

Remarks:
Amended claims in accordance with Rule 137(2) EPC.

(54) **Mobile communications device including an RF transmitter providing impedance fluctuation dampening and related methods**

(57)    A mobile communications device (30) may include an RF signal source (31) configured to generate RF signals over an RF frequency band, and an RF transmitter coupled to the RF signal source (31). The RF transmitter may include an RF amplifier (33) configured to operate over different power control levels. The RF amplifier (33) may have an input configured to receive the RF signals from the RF signal source (31) and an output having an impedance which changes based upon changes between the different power control levels. The RF transmitter may further include a shunt resistor (34) coupling the output of the amplifier (33) to a voltage reference (35), and the shunt resistor (34) may be configured to decrease a highest impedance change of the RF amplifier output to below a threshold impedance level. An antenna (36) may be coupled to the output of the RF amplifier (33).

FIG. 1

EP 2 670 049 A1

**Description**

**Technical Field**

This application relates to the field of communications, and more particularly, to mobile wireless communications systems and related methods.

**Background**

Mobile communication systems continue to grow in popularity and have become an integral part of both personal and business communications. Various mobile devices now incorporate Personal Digital Assistant (PDA) features such as calendars, address books, task lists, calculators, memo and writing programs, media players, games, etc. These multi-function devices usually allow electronic mail (email) messages to be sent and received wirelessly, as well as access the internet via a cellular network and/or a wireless local area network (WLAN), for example.

Mobile communication devices are required to meet certain operational standards for the respective frequency bands over which they communicate. For example, UMTS cellular devices are typically required to meet inner loop power control (ILPC) requirements. ILPC in the uplink is the ability of the mobile  transmitter to adjust its output power in accordance with one or more transmit power control (TPC) commands received in the downlink. The mobile transmitter may be required to change its output power with various step sizes (e.g., 1 dB, 2 dB and 3 dB) while remaining within a certain power control range.

**Brief Description of the Drawings**

FIG. 1 is a schematic block diagram of a mobile communications device in accordance with an example embodiment.

FIGS. 2 and 3 are schematic block diagrams of example implementations of the RF transmitter of the mobile communications device of FIG. 1.

FIG. 4 is a set of three tables illustrating impedance values for the transmitter configuration of FIG. 3 measured without a shunt resistor, measured with a shunt resistor, and predicted with the shunt resistor.

FIG. 5 is a graph of impedance deviation vs. automatic gain control steps for the tables of FIG. 4.

FIG. 6 is a Smith chart plot of the measured and predicted data from the tables of FIG. 4.

FIG. 7 is a Smith cart plot comparing the measured data from the tables of FIG. 4.

FIGS. 8-10 are a series of schematic diagrams illustrating various example shunt resistor configurations that may be used with the RF transmitter of FIG. 1.

FIGS. 11 is a graph of measured test results for ILPC step E testing of the mobile communications device of FIG. 1 with and without an impedance dampening shunt resistor.

FIGS. 12 is a graph of measured test results for ILPC step F testing of the mobile communications device of FIG. 1 with and without an impedance dampening shunt resistor.

FIG. 13 is a schematic block diagram illustrating example mobile communications device components that may be used with the mobile communications device shown in FIG. 1.

**Detailed Description**

The present description is made with reference to the accompanying drawings, in which embodiments are shown. However, many different embodiments may be used, and thus the description should not be construed as limited to the embodiments set forth herein. Rather, these embodiments are provided so that this disclosure will be thorough and complete. Like numbers refer to like elements throughout.

Generally speaking, a mobile communications device is provided herein which may include a radio frequency (RF) signal source configured to generate RF signals over at least one RF frequency band, and an RF transmitter coupled to the RF signal source. The RF transmitter may include an RF amplifier configured to operate over a plurality of different power control levels. The RF amplifier may have an input configured to receive the RF signals from the RF signal source and an output having an impedance which changes based upon changes between the different power control levels. The RF transmitter may further include at least one shunt resistor coupling the output of the amplifier to a voltage reference, and the at least one shunt resistor may be configured to decrease a highest impedance change of the RF amplifier output to below a threshold impedance level. The mobile communications device may further include at  least one antenna coupled to the output of the RF amplifier and configured to operate over the at least one RF frequency band. Thus, the RF transmitter may advantageously be configured to provide an output that remains with desired testing or operational parameters, such as inner loop power control (ILPC) output level parameters for Universal Mobile Telecommunications System (UMTS) frequency band operation, for example, as a result of the impedance dampening provided by the at least one shunt resistor.

More particularly, the mobile communications device may optionally include a pass-band filter, such as a surface acoustic wave (SAW) filter, for example, having an input coupled to the output of the amplifier, and an output coupled to the at least one antenna. In accordance with one example, the at least one shunt resistor may comprise a plurality of parallel-connected resistors. In accordance with another example, the at least one shunt resistor may comprise a plurality of series-connected resistors. Other examples may include a pi resistor network, a T resistor network, etc.

The mobile communications device may further include at least one of a capacitor and an inductor coupled in series or in parallel with the at least one shunt resistor. By way of example, the voltage reference may comprise ground.

A related method for making a mobile communications device may include coupling an input of an RF amplifier to an RF signal source. The RF signal source may be configured to generate RF signals over at least one RF frequency band, and the RF amplifier may be configured to operate over a plurality of different power control levels and have an output with an impedance which changes based upon changes between the different power control levels. The method may further include determining a highest impedance change of the RF amplifier output based upon the changes between the different power control levels, and coupling at least one shunt resistor between the output of the amplifier and a voltage reference, where the at least one shunt resistor may be configured to decrease a highest impedance change of the RF amplifier output to below a threshold impedance level. The method may further include coupling at least one antenna to the output of the RF amplifier, where the at least one antenna may be configured to operate over the at least one RF frequency band.

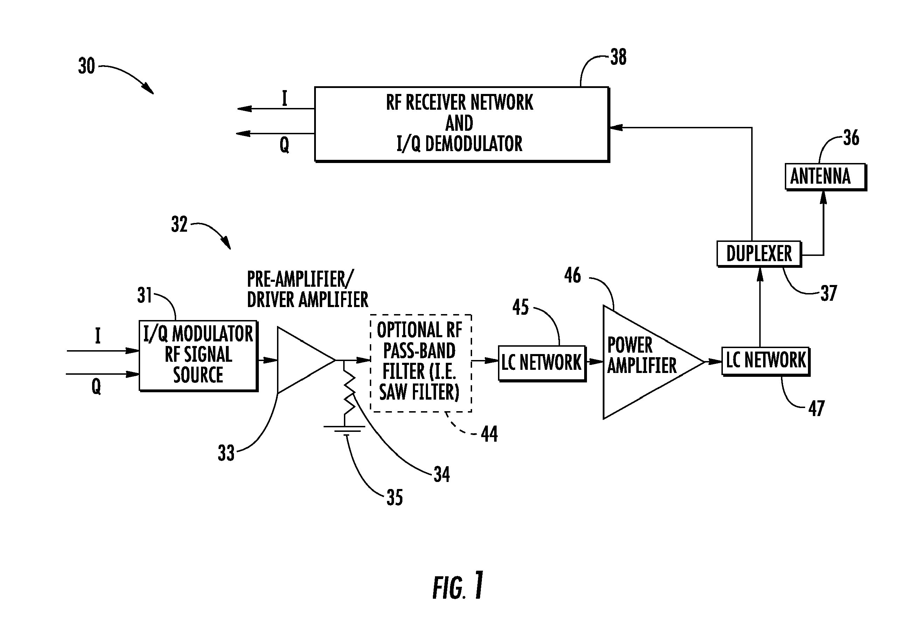

Referring initially to FIG. 1, a mobile communications device 30 is first described. Example mobile communications devices 30 may include portable or personal media players (e.g., music or MP3 players, video players, etc.), portable gaming devices, portable or mobile telephones, smartphones, tablet computers, digital cameras, etc. The mobile communications device **30** illustratively includes a radio frequency (RF) transmit path **32** including an RF signal source **31** configured to generate RF signals over one or more RF frequency bands. By way of example, the RF signal source **31** may include a modulator and other appropriate components for modulating information or data to be transmitted by the mobile communications device **30** to desired transmission frequencies. In the illustrated example, the RF signal source **31** comprises an I/Q modulator RF signal source, although other RF signal sources may be used in different embodiments. In the context of the present description, UMTS cellular frequency bands are discussed for purposes of illustration, but the devices and methods described herein may also be used with other cellular or wireless frequency bands in different embodiments.

The RF transmit path **32** further illustratively includes an RF amplifier **33,** which in the present example is configured as a pre-amplifier or driver amplifier. The RF pre-amplifier **33** is configured to operate over a plurality of different power control levels. The pre-amplifier **33** has an input configured to receive the RF signals from the RF signal source **31,** and an output having an impedance which changes based upon changes between the different power control levels, as will be described further below. The pre-amplifier **33** may be implemented as a discrete component, or it may be included along with other components in an integrated circuit (IC) package, for example.

One or more shunt resistors **34** are illustratively coupled between the output of the pre-amplifier 33 and a voltage reference, which in the present example is ground **35**, although other voltage references may be used in different embodiments. The shunt resistor **34** is configured to decrease a highest impedance change of the RF amplifier **33** output to below a threshold impedance level, as will also be discussed further below. It should be noted that while the shunt resistor **34** is described in the present example as being associated with the output of the RF pre-amplifier **33,** the impedance dampening techniques described herein may be used with other amplifier configurations as well.

The mobile communications device **30** further illustratively includes an optional RF pass-band filter **44,** such as a surface acoustic wave (SAW) filter, coupled to the output of the RF pre-amplifier **33** and configured to operate over the appropriate RF frequency band(s). The output of the filter **44** may optionally be coupled to a first LC network **45,** which has an output coupled to an input of an RF power amplifier **46,** and the RF power amplifier has an output coupled to a second LC network **47**. A duplexer **37** selectively couples an antenna **36** between the second LC network **47** or an RF receiver network-I/Q demodulator path **38** of the mobile communications device **30.**

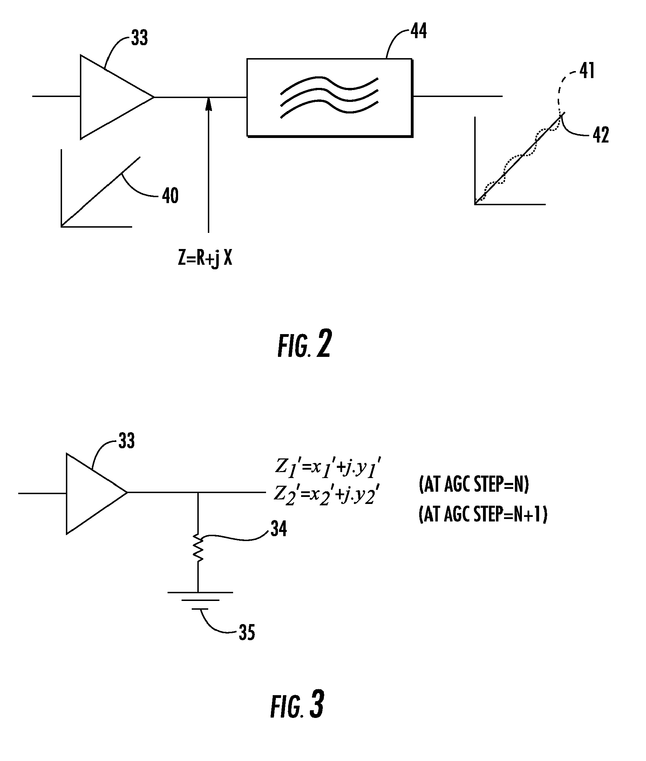

The undesirable change of output impedance of the pre-amplifier **33** is illustrated in FIG. 2, in which a linear ramping input signal **40** (shown in the graph under the amplifier) causes an impedance Z of the amplifier output to aberrantly change with changes in power control level across the dynamic operating range of the pre-amplifier. The output impedance Z of the pre-amplifier 33 is represented by the equation $Z = R + jX$, as shown. As shown by the graph at the output of the filter **44,** the an output signal **41** represented with a dashed line includes several variations which represent deviations from the ideal linear ramping signal **42** that result from the changes or fluctuations in the output impedance of the pre-amplifier **33** as it is driven throughout its dynamic range of operation.

More particularly, when the output load to the pre-amplifier **33** is a SAW filter, for example, the changes in the pre-amplifier output impedance can change the pass-band response of the SAW filter. The instantaneous changes in load impedance directly impact the SAW filter frequency response, and may adversely affect a signal which is ramping in a linear manner. As the input load impedance to the SAW filter varies, it causes variations in the SAW filter return loss and insertion loss. Typically, transmit channel frequency compensation calibration is performed at one fixed power level. However, a typical calibration approach will not compensate for the varying frequency response across the different transmit power levels. As such, these variations increase the error in ILPC performance. Such distortion of a linear ramping signal may adversely impact mobile transmitter performance in relation to the inner loop power control (ILPC) requirements, as specified in section 5.4.2. of the 3GPP TS 34.121 V6.0.0 (2005-03) Technical Specification entitled "3rd Generation Partnership Project; Technical Specification Group Terminals; Terminal conformance specification; Radio transmission and reception (FDD) (Release 6)", which is hereby incorporated herein in its entirety by reference.

The shunt resistor(s) **34** may advantageously be used to dampen the effect of the instantaneous changes in the output impedance of the pre-amplifier **33**. This dampening effect tends to reduce the variation in input impedance to the SAW filter **44,** for example. Consequently, as the filter input impedance is held more constant, the pass-band frequency response of the SAW filter tends to show less variation. With less variation in the pass-band frequency response, a signal which is ramping in a linear manner tends to maintain the characteristics of the linear ramp, which in turn advantageously reduces error in ILPC steps, for example.

More particularly, section 5.4.2 of the 3GPP ETSI TS 34.121 defines the requirements for Inner Loop Power Control in the uplink. In general terms, when the mobile device is directed by the base station to increase or decrease its transmit power in 1 dB increments, then the mobile device has to increase or decrease its transmit power by 1 dB within a +/- 0.5 dB window of error. Steps "E" and Step "F" of the ILPC requirement may be particularly difficult sections of the test to pass, since these portions of the test stress the power amplifier and preamplifiers by increasing/decreasing the transmit power throughout the dynamic range of the RF transmitter **32**. Typically this range is from -60 dBm to + 24 dBm, although other test configurations may be used in different embodiments.

As noted above, the approach set forth herein advantageously uses a one or more shunt resistors **34** to dampen variation in the output impedance of the pre-amplifier **33**. The shunt resistance tends to clamp the amount of variation in the output impedance of the pre-amplifier **33**. The shunt resistor **44** does not eliminate the variation, but instead restricts the variation so that the pass-band response of the SAW filter is held more constant over the signal ramp, such as during step "E" and step "F" of the ILPC test, for example. This keeps the frequency response more constant as the power level varies.

An example approach for determining appropriate shunt resistor **34** values for different RF transmitter path 32 configurations is now described with reference to FIGS. 3 through 7. More particularly, this approach allows for evaluation of a shunt resistor(s) **34** values that are based on worst case test results during an ILPC measurement for UMTS bands, although these techniques may also be applicable to other frequency bands and operating configurations, for example. The calculated value of the shunt resistor **34** is implemented at the output of the pre-amplifier **33,** as shown in the schematic diagram of FIG. 3, and measured results will demonstrate how the margins for ILPC are improved based upon this configuration.

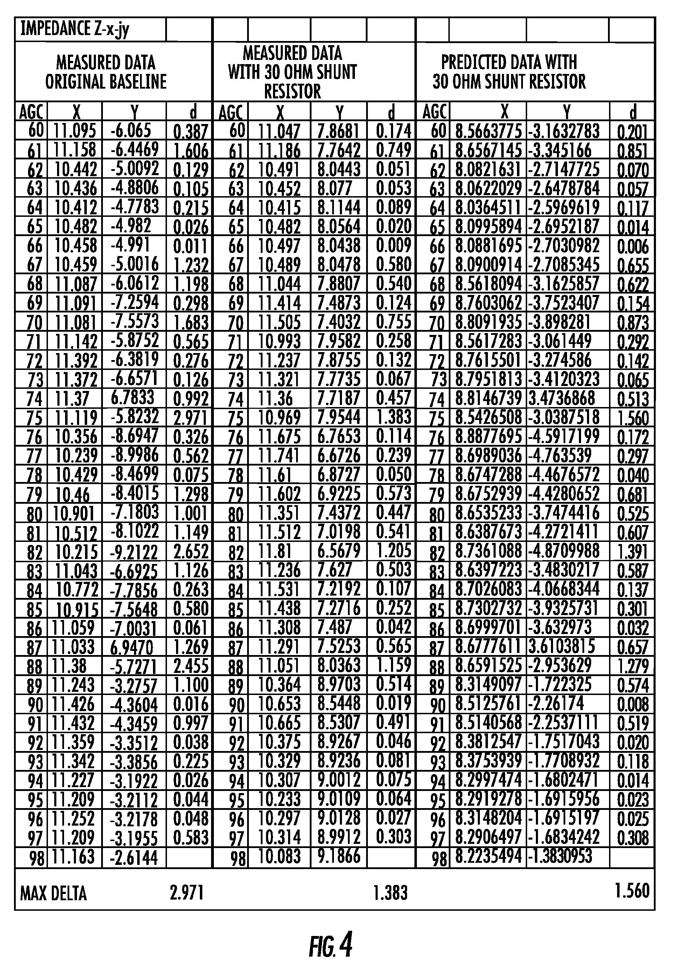

An example methodology for choosing the shunt resistor 34 value is as follows. At the system level, a region of worst case ILPC performance may be measured and recorded, along with the corresponding AGC values for the pre-amplifier **33**. Furthermore, at the device level, data may be gathered on the output impedance of the pre-amplifier **33** as the AGC is stepped through the dynamic range of interest. Using equation set 1 below, the location of the worst case impedance variation as the AGC is stepped over the operating frequency range is determined. The values $Z_1$ and $Z_2$ represent the impedance measured at consecutive AGC steps. More specifically, $Z_1$ and $Z_2$ are measured impedances at consecutive AGC steps where the worst case (i.e., greatest) impedance variation $d_o$ is observed. The first table of FIG. 4 shows the relative impedance variation $d_o$ versus AGC settings for the original measured baseline data for the pre-amplifier 33 in an example UMTS transmitter implementation with no shunt resistor coupled to its output.

$$\text{Equation Set 1:}$$

$$Z_1 = x_1 + j \cdot y_1$$
$$Z_2 = x_2 + j \cdot y_2$$

$$d_o = \sqrt{(x_1 - x_2)^2 + (y_1 - y_2)^2}$$

Equation set 1 demonstrates the relative impedance change. For example, $Z_1$ represents the measured impedance at AGC = N, and $Z_2$ represents the measured impedance at AGC = N+1. This allows the relative impedance change do to be calculated so that it may be determined where the impedance change is the largest, which is typically where ILPC errors will occur.

Next, a shunt resistor to ground may be placed on the output of the pre-amplifier **33** to dampen the impedance variations. These impedance variations bring about ILPC errors at the system level. In the example shown in FIG. 3, a single shunt resistor **34** couples the output of the amplifier **33** to ground **35** to dampen the output impedance variations, although other resistor configurations may be used, as will be discussed further below. Using equation set 2 below, the impedance variation dampening effect of different shunt resistor values may be determined. The second and third tables of FIG. 4 respectively show measured and calculated data for an example case of a single shunt resistor **34** having a value of 30 Ohms coupling the output of the pre-amplifier **33** to ground **35.**

$$\text{Equation Set 2:}$$

$$Z_1' = x_1' + j \cdot y_1'$$
$$Z_2' = x_2' + j \cdot y_2'$$

$$x_1' = \frac{R^2 \cdot x_1 + R \cdot x_1^2 + R \cdot y_1^2}{R^2 + 2 \cdot R \cdot x_1 + x_1^2 + y_1^2}$$

$$y_1' = \frac{R^2 \cdot y_1}{R^2 + 2 \cdot R \cdot x_1 + x_1^2 + y_1^2}$$

$$x_2' = \frac{R^2 \cdot x_2 + R \cdot x_2^2 + R \cdot y_2^2}{R^2 + 2 \cdot R \cdot x_2 + x_2^2 + y_2^2}$$

$$y_2' = \frac{R^2 \cdot y_2}{R^2 + 2 \cdot R \cdot x_2 + x_2^2 + y_2^2}$$

$$d_o' = \sqrt{(x_1' - x_2')^2 + (y_1' - y_2')^2}$$

Generally speaking, an appropriate value for the shunt resistor **34** will be one which provides sufficient dampening of the impedance variations, yields corresponding ILPC improvements, and still yields acceptable signal output power from the amplifier **33.** As noted above, measured and predicted data with a 30 Ohm shunt resistor **34** is shown in FIG. 4. The predicted data X and Y values vary from the measured values partly due to the phase rotation of the transmission line used during measurement, although the impedance changes correspond relatively closely. The largest variation in impedance (2.971) occurs between AGC steps 75 and 76.

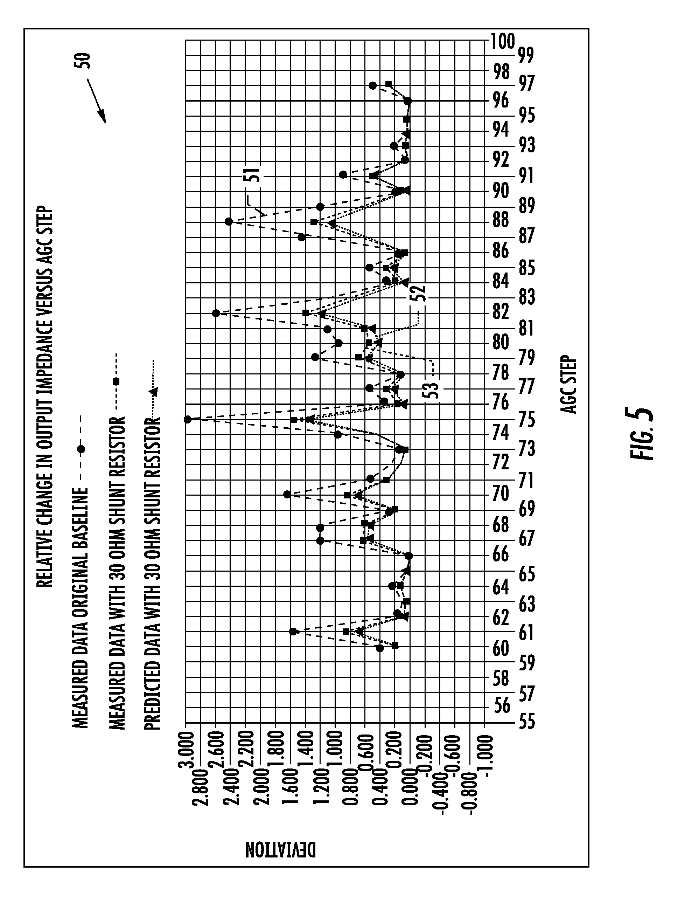

A graph **50** is shown in FIG. 5 which illustrates the tabular data from the tables of FIG. 4. The original measured baseline data without the shunt resistor **34** is represented by the graph line **51**. The measured and predicted data for a 30 Ohm shunt resistor **34** is respectively represented by the graph lines **52** and **53.** The addition of the 30 ohm shunt resistor **34** provides a reduction in the impedance changes or deviation $d_o$ of approximately 50%. It will also be observed that the predicted relative impedance variation corresponds well with the measured impedance variation, which may advantageously allow for different shunt resistor configurations to be simulated to determine expected results without having to build numerous different circuit models, for example.

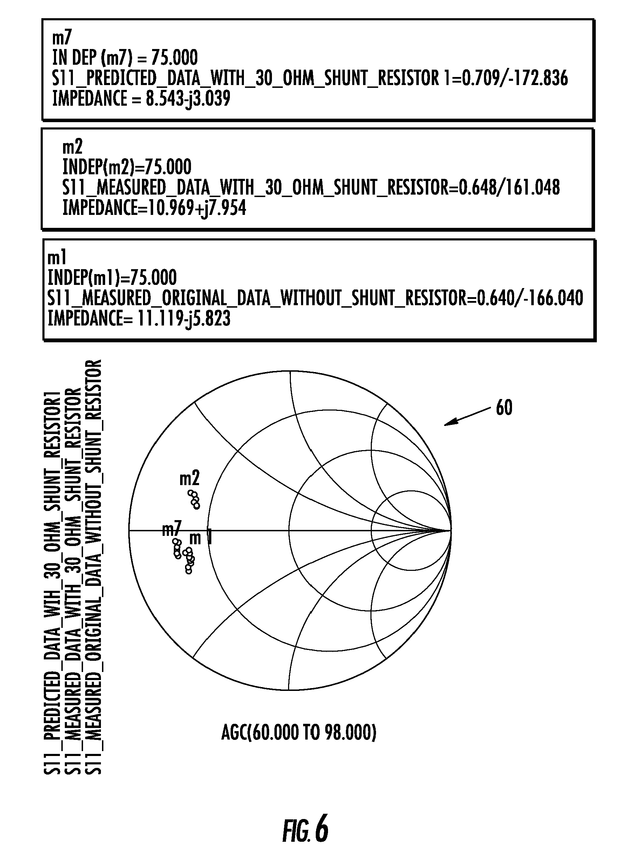

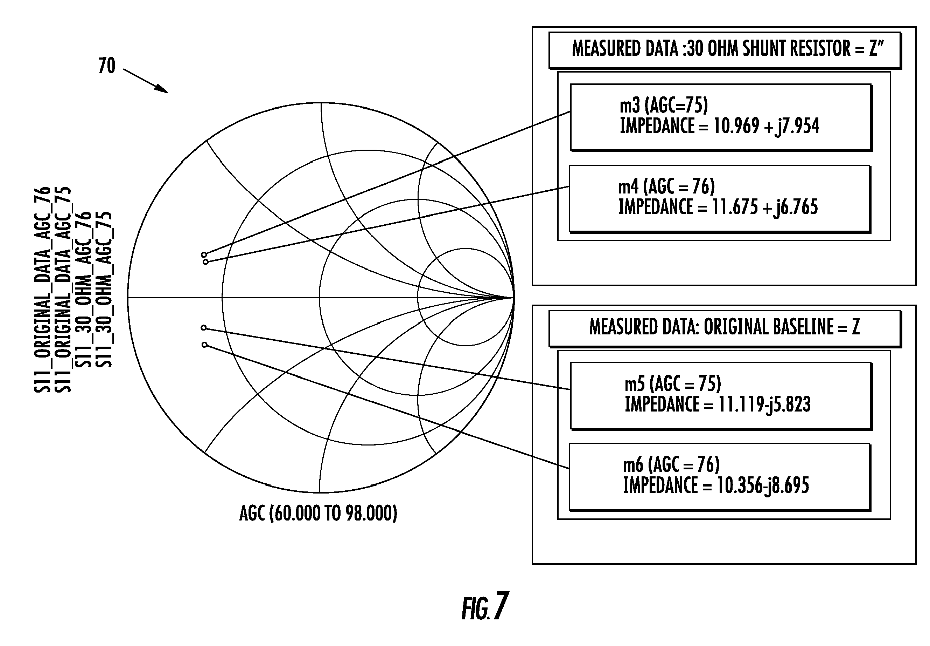

A corresponding Smith chart **60** of the measured and predicted data from the tables of FIG. 4 is shown in FIG. 6. In the chart **60,** a marker m1 indicates the original measure S11 data without the 30 Ohm shunt resistor **34,** while the markers m2 and m7 respectively indicate measured and predicted S11 data with the 30 Ohm shunt resistor. Moreover, a Smith chart 70 of FIG. 7 illustrates the difference in the measured data with and without the 30 Ohm shunt resistor **34** at AGC steps 75 and 76. As previously discussed, AGC step 75 and step 76 in this example represent the region of greatest impedance variation. The original amplifier **33** output impedance is plotted with markers m5 and m6, which show a relative $d_o$ = 2.97 for AGC steps 75 and 76. Next, the 30 ohm shunt resistor **34** is coupled between the output of the pre-amplifier **33** and ground **35.** Markers m3 and m4 show the pre-amplifier **33** output impedance with the 30 ohm shunt resistor **34** placed on the output. Measured data shows the reduced/dampened impedance variation and a relative $d_o'$ - 1.38. Again, it will be seen that the impedance variation has been reduced by more than 50%. Different targets for impedance variation reduction (e.g., 25%, 50%, 75%, etc.) may be chosen based upon the amount of dampening that is required to meet applicable ILPC and signal output requirements in some embodiments.

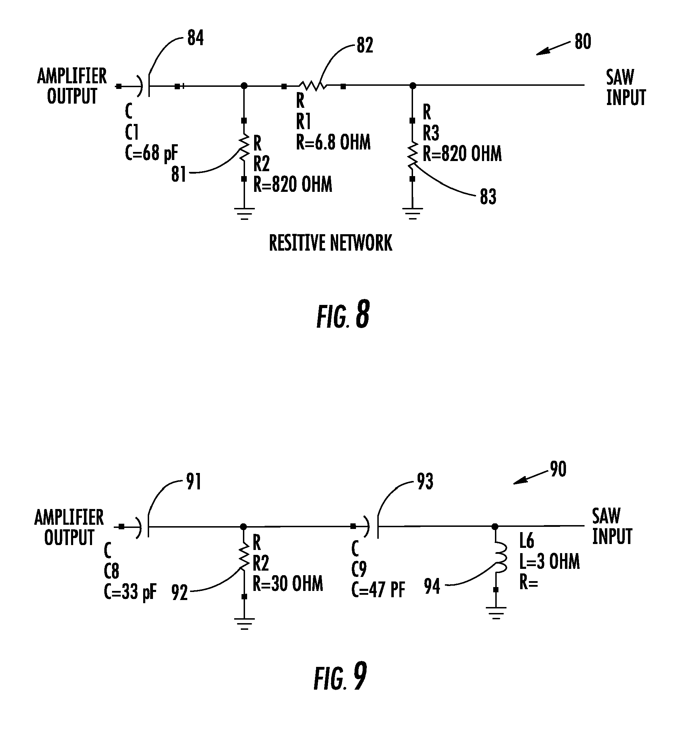

As noted above, different shunt resistor configurations may be used in different embodiments. For example, a shunt resistor network **80** is shown in FIG. 8 which includes a capacitor **84** (61 pF) coupled to the output of the amplifier **33,** a resistor **81** (820 Ohm) coupled between the capacitor and ground, a resistor **82** (6.8 Ohm) coupled between the capacitor and the filter **44** input, and a resistor 83 (820 Ohm) coupled between the SAW filter input and ground. More particularly, the resistors **81, 82, 83** are arranged in a "pi" configuration as shown. In another similar embodiment, the resistors **81, 82, 83** may instead be arranged in a "T" configuration, for example, with or without additional capacitors, inductors, resistors, etc.

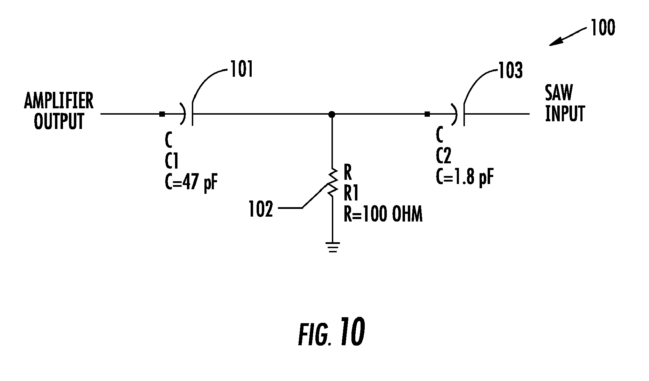

In another example embodiment shown in FIG. 9, a shunt resistor network **90** illustratively includes a capacitor **91** (33 pF) coupled to the output of the amplifier **33,** a resistor **92** (30 Ohm) coupled between the capacitor **91** and ground, a capacitor **93** (4.7 pF) coupled between the capacitor **91** and the SAW filter **44** input, and an inductor **94** (3.3 nH) coupled between the SAW filter input and ground. Another similar configuration is shown in FIG. 10, in which a shunt resistor network **100** illustratively includes a capacitor **101** (47 pF) coupled to the output of the amplifier 33, a resistor **102** (100 Ohm) coupled between the capacitor **101** and ground, and a capacitor **103** (1.8 pF) coupled between the capacitor **101** and the SAW filter **44** input. Other suitable shunt resistor configurations may also be used for various RF transmitter configurations.

The above-described shunt resistance networks may also advantageously be used to help "clamp" the amount of variation in the output impedance of the amplifier **33** as described above for a single shunt resistor **34.** By restricting the variation of the impedance, the pass-band response of the SAW filter **44** is held more constant over the signal ramp during step "E" and step "F" of the ILPC test, for example. This keeps the frequency response more constant as the power level varies.

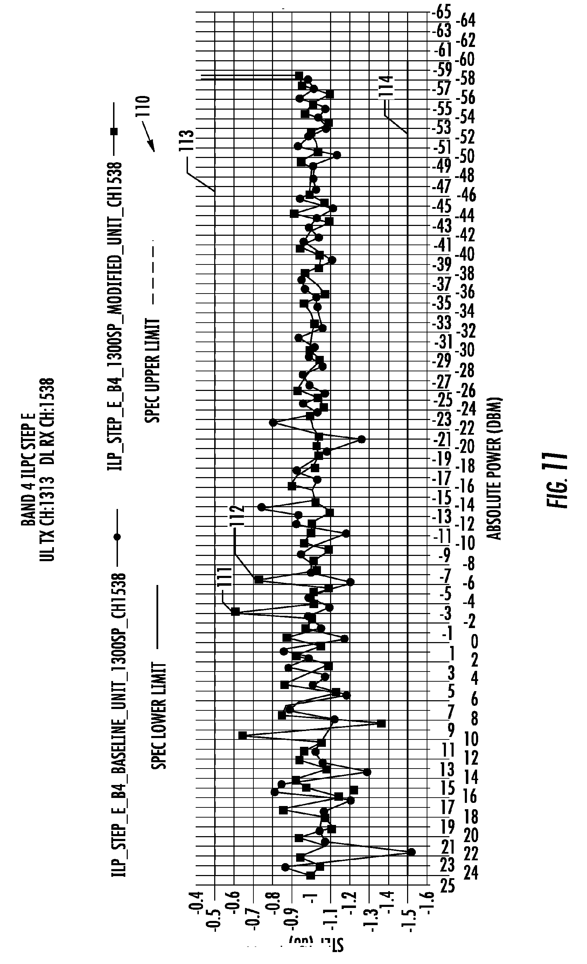

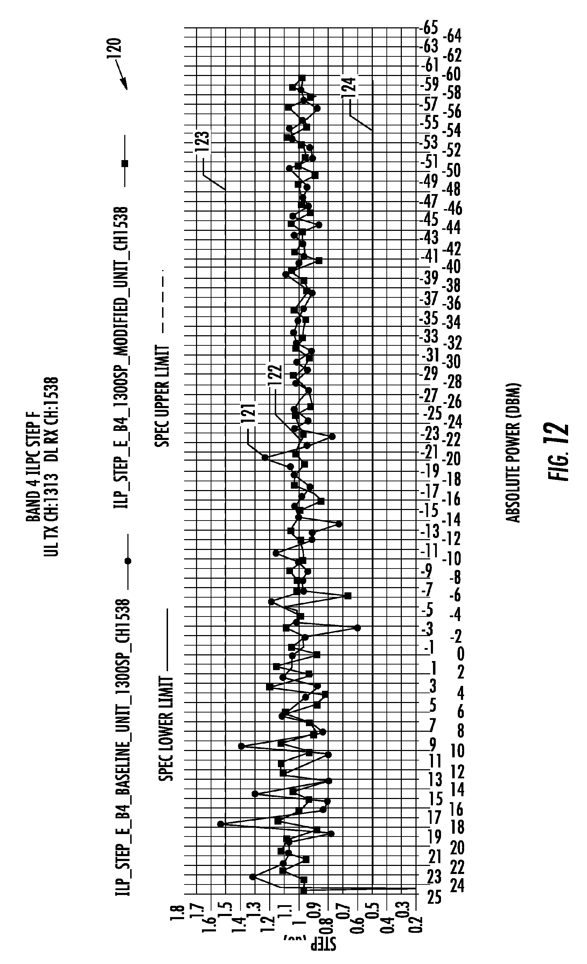

More particularly, measured ILPC test results for steps E and F are respectively shown in the graphs **110** and **120** of FIGS. 11 and 12. For these test configurations, an RF transmitter chain **32** as shown in FIG. 1 with a 30 Ohm shunt resistor **34** was used. For the graph **110,** the baseline measurements without the shunt resistor **34** are represented by the graph line **111,** while the measurements taken with the addition of the shunt resistor are represented by the graph line **112.** The upper and lower ILPC specification limits for step E are represented by horizontal lines **113** and **114,** respectively. In this test configuration, the inclusion of the shunt resistor **34** avoids a lower specification limit failure between absolute power values of 21 and 22 dBm, as shown.

For the graph 120, the baseline measurements without the shunt resistor **34** are represented by the graph line **121,** while the measurements taken with the addition of the shunt resistor are represented by the graph line **122.** The upper and lower ILPC specification limits for step F are represented by horizontal lines **123** and **124,** respectively. In this test configuration, the inclusion of the shunt resistor 34 avoids an upper specification limit failure between absolute power values of 17 and 18 dBm, as shown.

In addition, the above-described approach may advantageously provide a relatively low cost approach that has small or minimal impact on PCB board space. Furthermore, it may also advantageously be used to improve ILPC performance across all channels in an RF frequency band, and particularly on UMTS end channels. Current 3GPP specifications require testing only on mid-channels. However, in some cases, additional requirements from carriers, etc., may be applicable that necessitate ILPC performance to meet the specification on end channels as well, for example. The above-described approach may also reduce the need for any special or unique changes or compensations to the modem software or calibration software.

Another potential advantage of the above-described approach is that it may reduce the necessity for collecting large volumes of factory yield data to refine ILPC performance through software methods such as the modification of nonvolatile memory parameters. This may be significant in that analysis of factory data is typically an iterative process which occurs over the build of several thousand units. Moreover, the above-described approach may also reduce dependency on temperature variations and component variations, as well as potentially avoiding special calibration procedures. More particularly, the complexity of factory calibration routines may be reduced, including calibration of end channels. By not having to specifically calibrate the end channels, time may accordingly be saved during the factory calibration process, which may translate to cost savings. Another significant consideration of the above-described approach is that it may result in a relatively low impact on current consumption versus transmit output power. The increased current consumption was found to be less than 1% in the above-noted test configuration including the shunt resistor **34.**

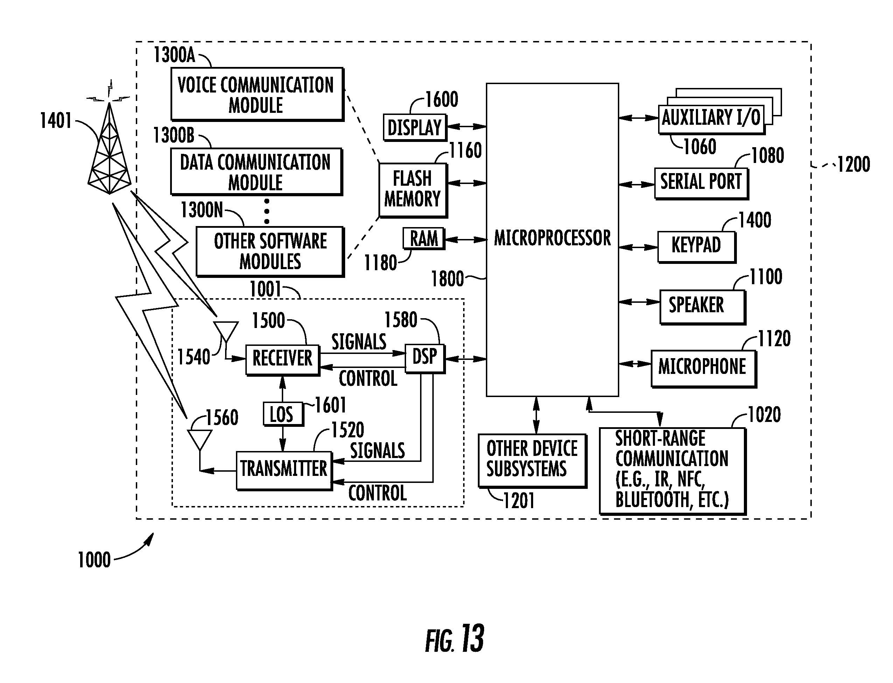

Example components of a mobile communications device 1000 that may be used in accordance with the above-described embodiments are further described below with reference to FIG. 13. The device **1000** illustratively includes a housing **1200,** a keyboard or keypad **1400** and an output device **1600.** The output device shown is a display **1600,** which may comprise a full graphic LCD. Other types of output devices may alternatively be utilized. A processing device **1800** is contained within the housing **1200** and is coupled between the keypad **1400** and the display **1600.** The processing device **1800** controls the operation of the display **1600,** as well as the overall operation of the mobile device **1000,** in response to actuation of keys on the keypad **1400.**

The housing **1200** may be elongated vertically, or may take on other sizes and shapes (including clamshell housing structures). The keypad may include a mode selection key, or other hardware or software for switching between text entry and telephony entry.

In addition to the processing device **1800,** other parts of the mobile device **1000** are shown schematically in FIG. 13. These include a communications subsystem **1001;** a short-range communications subsystem **1020;** the keypad **1400** and the display **1600,** along with other input/output devices **1060, 1080, 1100** and **1120;** as well as memory devices **1160, 1180** and various other device subsystems **1201.** The mobile device **1000** may comprise a two-way RF communications device having data and, optionally, voice communications capabilities. In addition, the mobile device **1000** may have the capability to communicate with other computer systems via the Internet.

Operating system software executed by the processing device **1800** is stored in a persistent store, such as the flash memory **1160,** but may be stored in other types of memory devices, such as a read only memory (ROM) or similar storage element. In addition, system software, specific device applications, or parts thereof, may be temporarily loaded into a volatile store, such as the random access memory (RAM) **1180.** Communications signals received by the mobile device may also be stored in the RAM 1180.

The processing device **1800,** in addition to its operating system functions, enables execution of software applications **1300A-1300N** on the device **1000.** A predetermined set of applications that control basic device operations, such as data and voice communications **1300A** and **1300B,** may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401.** The PIM data items may be seamlessly integrated, synchronized and updated via the wireless network **1401** with corresponding data items stored or associated with a host computer system.

Communication functions, including data and voice communications, are performed through the communications subsystem **1001,** and possibly through the short-range communications subsystem. The communications subsystem **1001** includes a receiver **1500,** a transmitter **1520,** and one or more antennas **1540** and **1560.** In addition, the communications subsystem **1001** also includes a processing module, such as a digital signal processor (DSP) **1580,** and local oscillators (LOs) **1601.** The specific design and implementation of the communications subsystem **1001** is dependent upon the communications network in which the mobile device **1000** is intended to operate. For example, a mobile device **1000** may include a communications subsystem **1001** designed to operate with the Mobitex™, Data TAC™ or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device **1000.** The mobile device **1000** may also be compliant with other communications standards such as 3GSM, 3GPP, UMTS, 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore typically involves use of a subscriber identity module, commonly referred to as a SIM card, in order to operate on a GPRS network.

When required network registration or activation procedures have been completed, the mobile device **1000** may send and receive communications signals over the communication network **1401.** Signals received from the communications network **1401** by the antenna **1540** are routed to the receiver **1500,** which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560.**

In addition to processing communications signals, the DSP 1580 provides for control of the receiver **1500** and the transmitter **1520.** For example, gains applied to communications signals in the receiver **1500** and transmitter **1520** may be adaptively controlled through automatic gain control algorithms implemented in the DSP **1580.**

In a data communications mode, a received signal, such as a text message or web page download, is processed by the communications subsystem **1001** and is input to the processing device **1800.** The received signal is then further processed by the processing device **1800** for an output to the display **1600,** or alternatively to some other auxiliary I/O device **1060.** A device may also be used to compose data items, such as e-mail messages, using the keypad **1400** and/or some other auxiliary I/O device **1060,** such as a touchpad, a rocker switch, a thumb-wheel, or some other type of input device. The composed data items may then be transmitted over the communications network **1401** via the communications subsystem 1001.

In a voice communications mode, overall operation of the device is substantially similar to the data communications mode, except that received signals are output to a speaker **1100,** and signals for transmission are generated by a microphone 1120. Alternative voice or audio I/O subsystems, such as a voice message recording subsystem, may also be implemented on the device **1000.** In addition, the display **1600** may also be utilized in voice communications mode, for example to display the identity of a calling party, the duration of a voice call, or other voice call related information.

The short-range communications subsystem enables communication between the mobile device 1000 and other proximate systems or devices, which need not necessarily be similar devices. For example, the short-range communications subsystem may include an infrared device and associated circuits and components, a Bluetooth™ communications module to provide for communication with similarly-enabled systems and devices, or a near field communications (NFC) sensor for communicating with a NFC device or NFC tag via NFC communications.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A mobile communications device comprising:

   a radio frequency (RF) signal source configured to generate RF signals over at least one RF frequency band;
   an RF transmitter coupled to said RF signal source and comprising
   an RF amplifier configured to operate over a plurality of different power control levels, said RF amplifier having an input configured to receive the RF signals from said signal source and an output having an impedance which changes based upon changes between the different power control levels, and
   at least one shunt resistor coupling the output of said amplifier to a voltage reference, said at least one shunt resistor configured to decrease a highest impedance change of the RF amplifier output to below a threshold impedance level; and
   at least one antenna coupled to the output of said RF amplifier and configured to operate over the at least one RF frequency band.

2. The mobile communications device of Claim 1 further comprising a pass-band filter having an input coupled to the output of said RF amplifier, and an output coupled to said at least one antenna.

3. The mobile communications device of Claim 2 wherein said pass-band filter comprises a surface acoustic wave (SAW) filter.

4. The mobile communications device of Claim 1 wherein said at least one shunt resistor comprises a plurality of parallel-connected resistors.

5. The mobile communications device of Claim 1 wherein said at least one shunt resistor comprises a plurality of series-connected resistors.

6. The mobile communications device of Claim 1 wherein said at least one shunt resistor comprises a pi resistor network.

7. The mobile communications device of Claim 1 wherein said at least one shunt resistor comprises a T resistor network.

8. The mobile communications device of Claim 1 further comprising at least one of a capacitor and an inductor coupled in series with said at least one shunt resistor.

9. The mobile communications device of Claim 1 further comprising at least one of a capacitor and an inductor coupled in parallel with said at least one shunt resistor.

10. The mobile communications device of Claim 1 wherein the at least one RF frequency band comprises at least one Universal Mobile Telecommunications System (UMTS) frequency band.

11. The mobile communications device of Claim 1 wherein the threshold impedance level is based upon an inner loop power control (ILPC) output level.

12. A method for making a mobile communications device comprising:

coupling an input of a radio frequency (RF) amplifier to an RF signal source, the RF signal source being configured to generate RF signals over at least one RF frequency band, and the RF amplifier being configured to operate over a plurality of different power control levels and having an output with an impedance which changes based upon changes between the different power control levels;

determining a highest impedance change of the RF amplifier output based upon the changes between the different power control levels; and

coupling at least one shunt resistor between the output of the amplifier and a voltage reference, the at least one shunt resistor being configured to decrease a highest impedance change of the RF amplifier output to below a threshold impedance level.

13. The method of Claim 12 further comprising coupling an input of pass-band filter to the output of the RF amplifier, and an output of the pass-band filter to the at least one antenna.

14. The method of Claim 12 wherein the pass-band filter comprises a surface acoustic wave (SAW) filter.

15. The method of Claim 12 wherein the at least one shunt resistor comprises a plurality of parallel-connected resistors.


**Amended claims in accordance with Rule 137(2) EPC.**

1. A mobile communications device (30) comprising:

a radio frequency "RF" signal source (31) configured to generate RF signals over at least one RF frequency band;

an RF transmitter (32) coupled to said RF signal source and comprising

an RF amplifier (33) configured to operate over a plurality of different power control levels, said RF amplifier having an input configured to receive the RF signals from said signal source and an output having an impedance which changes based upon changes between the different power control levels, and

at least one shunt resistor (34) coupling the output of said amplifier to a voltage reference (35), said at least one shunt resistor configured to decrease a highest relative impedance change of the RF amplifier output between consecutive power control levels to below a threshold impedance level; and

at least one antenna (36) coupled to the output of said RF amplifier and configured to operate over the at least one RF frequency band.

2. The mobile communications device of Claim 1 further comprising a pass-band filter (44) having an input coupled to the output of said RF amplifier, and an output coupled to said at least one antenna.

3. The mobile communications device of Claim 2
wherein said pass-band filter comprises a surface acoustic wave (SAW) filter.

4. The mobile communications device of Claim 1
wherein said at least one shunt resistor comprises a plurality of parallel-connected resistors (81, 83).

5. The mobile communications device of Claim 1
wherein said at least one shunt resistor comprises a plurality of series-connected resistors (82, 83).

6. The mobile communications device of Claim 1
wherein said at least one shunt resistor comprises a pi resistor network (81, 82, 83).

7. The mobile communications device of Claim 1
wherein said at least one shunt resistor comprises a T resistor network.

8. The mobile communications device of Claim 1 further comprising at least one of a capacitor (84, 91, 101) and an inductor coupled in series with said at least one shunt resistor.

**9.** The mobile communications device of Claim 1 further comprising at least one of a capacitor (93, 103) and an inductor (94) coupled in parallel with said at least one shunt resistor.

**10.** The mobile communications device of Claim 1
wherein the at least one RF frequency band comprises at least one Universal Mobile Telecommunications System (UMTS) frequency band.

**11.** The mobile communications device of Claim 1
wherein the threshold impedance level is based upon an inner loop power control (ILPC) output level.

**12.** A method for making a mobile communications device comprising:

coupling an input of a radio frequency (RF) amplifier to an RF signal source, the RF signal source being configured to generate RF signals over at least one RF frequency band, and the RF amplifier being configured to operate over a plurality of different power control levels and having an output with an impedance which changes based upon changes between the different power control levels;
determining a highest relative impedance change of the RF amplifier output between consecutive power control levels based upon the changes between the different power control levels; and
coupling at least one shunt resistor between the output of the amplifier and a voltage reference, the at least one shunt resistor being configured to decrease the highest relative impedance change of the RF amplifier output to below a threshold impedance level.

**13.** The method of Claim 12 further comprising coupling an input of pass-band filter to the output of the RF amplifier, and an output of the pass-band filter to the at least one antenna.

**14.** The method of Claim 12 wherein the pass-band filter comprises a surface acoustic wave (SAW) filter.

**15.** The method of Claim 12 wherein the at least one shunt resistor comprises a plurality of parallel-connected resistors.

*FIG. 1*

EP 2 670 049 A1

33

44

41

40

42

Z=R+j X

*FIG.* 2

33

$Z_1'=x_1'+j.y_1'$    (AT AGC STEP=N)
$Z_2'=x_2'+j.y_2'$    (AT AGC STEP=N+1)

34

35

*FIG.* 3

| IMPEDANCE Z-x-jy | | | | | | | | | | | |
|---|---|---|---|---|---|---|---|---|---|---|---|
| MEASURED DATA ORIGINAL BASELINE | | | | MEASURED DATA WITH 30 OHM SHUNT RESISTOR | | | | PREDICTED DATA WITH 30 OHM SHUNT RESISTOR | | | |
| AGC | X | Y | d | AGC | X | Y | d | AGC | X | Y | d |
| 60 | 11.095 | -6.065 | 0.387 | 60 | 11.047 | 7.8681 | 0.174 | 60 | 8.5663775 | -3.1632783 | 0.201 |
| 61 | 11.158 | -6.4469 | 1.606 | 61 | 11.186 | 7.7642 | 0.749 | 61 | 8.6567145 | -3.345166 | 0.851 |
| 62 | 10.442 | -5.0092 | 0.129 | 62 | 10.491 | 8.0443 | 0.051 | 62 | 8.0821631 | -2.7147725 | 0.070 |
| 63 | 10.436 | -4.8806 | 0.105 | 63 | 10.452 | 8.077 | 0.053 | 63 | 8.0622029 | -2.6478784 | 0.057 |
| 64 | 10.412 | -4.7783 | 0.215 | 64 | 10.415 | 8.1144 | 0.089 | 64 | 8.0364511 | -2.5969619 | 0.117 |
| 65 | 10.482 | -4.982 | 0.026 | 65 | 10.482 | 8.0564 | 0.020 | 65 | 8.0995894 | -2.6952187 | 0.014 |
| 66 | 10.458 | -4.991 | 0.011 | 66 | 10.497 | 8.0438 | 0.009 | 66 | 8.0881695 | -2.7030982 | 0.006 |
| 67 | 10.459 | -5.0016 | 1.232 | 67 | 10.489 | 8.0478 | 0.580 | 67 | 8.0900914 | -2.7085345 | 0.655 |
| 68 | 11.087 | -6.0612 | 1.198 | 68 | 11.044 | 7.8807 | 0.540 | 68 | 8.5618094 | -3.1625857 | 0.622 |
| 69 | 11.091 | -7.2594 | 0.298 | 69 | 11.414 | 7.4873 | 0.124 | 69 | 8.7603062 | -3.7523407 | 0.154 |
| 70 | 11.081 | -7.5573 | 1.683 | 70 | 11.505 | 7.4032 | 0.755 | 70 | 8.8091935 | -3.898281 | 0.873 |
| 71 | 11.142 | -5.8752 | 0.565 | 71 | 10.993 | 7.9582 | 0.258 | 71 | 8.5617283 | -3.061449 | 0.292 |
| 72 | 11.392 | -6.3819 | 0.276 | 72 | 11.237 | 7.8755 | 0.132 | 72 | 8.7615501 | -3.274586 | 0.142 |
| 73 | 11.372 | -6.6571 | 0.126 | 73 | 11.321 | 7.7735 | 0.067 | 73 | 8.7951813 | -3.4120323 | 0.065 |
| 74 | 11.37 | 6.7833 | 0.992 | 74 | 11.36 | 7.7187 | 0.457 | 74 | 8.8146739 | 3.4736868 | 0.513 |
| 75 | 11.119 | -5.8232 | 2.971 | 75 | 10.969 | 7.9544 | 1.383 | 75 | 8.5426508 | -3.0387518 | 1.560 |
| 76 | 10.356 | -8.6947 | 0.326 | 76 | 11.675 | 6.7653 | 0.114 | 76 | 8.8877695 | -4.5917199 | 0.172 |
| 77 | 10.239 | -8.9986 | 0.562 | 77 | 11.741 | 6.6726 | 0.239 | 77 | 8.6989036 | -4.763539 | 0.297 |
| 78 | 10.429 | -8.4699 | 0.075 | 78 | 11.61 | 6.8727 | 0.050 | 78 | 8.6747288 | -4.4676572 | 0.040 |
| 79 | 10.46 | -8.4015 | 1.298 | 79 | 11.602 | 6.9225 | 0.573 | 79 | 8.6752939 | -4.4280652 | 0.681 |
| 80 | 10.901 | -7.1803 | 1.001 | 80 | 11.351 | 7.4372 | 0.447 | 80 | 8.6535233 | -3.7474416 | 0.525 |
| 81 | 10.512 | -8.1022 | 1.149 | 81 | 11.512 | 7.0198 | 0.541 | 81 | 8.6387673 | -4.2721411 | 0.607 |
| 82 | 10.215 | -9.2122 | 2.652 | 82 | 11.81 | 6.5679 | 1.205 | 82 | 8.7361088 | -4.8709988 | 1.391 |
| 83 | 11.043 | -6.6925 | 1.126 | 83 | 11.236 | 7.627 | 0.503 | 83 | 8.6397223 | -3.4830217 | 0.587 |
| 84 | 10.772 | -7.7856 | 0.263 | 84 | 11.531 | 7.2192 | 0.107 | 84 | 8.7026083 | -4.0668344 | 0.137 |
| 85 | 10.915 | -7.5648 | 0.580 | 85 | 11.438 | 7.2716 | 0.252 | 85 | 8.7302732 | -3.9325731 | 0.301 |
| 86 | 11.059 | -7.0031 | 0.061 | 86 | 11.308 | 7.487 | 0.042 | 86 | 8.6999701 | -3.632973 | 0.032 |
| 87 | 11.033 | 6.9470 | 1.269 | 87 | 11.291 | 7.5253 | 0.565 | 87 | 8.6777611 | 3.6103815 | 0.657 |
| 88 | 11.38 | -5.7271 | 2.455 | 88 | 11.051 | 8.0363 | 1.159 | 88 | 8.6591525 | -2.953629 | 1.279 |
| 89 | 11.243 | -3.2757 | 1.100 | 89 | 10.364 | 8.9703 | 0.514 | 89 | 8.3149097 | -1.722325 | 0.574 |
| 90 | 11.426 | -4.3604 | 0.016 | 90 | 10.653 | 8.5448 | 0.019 | 90 | 8.5125761 | -2.26174 | 0.008 |
| 91 | 11.432 | -4.3459 | 0.997 | 91 | 10.665 | 8.5307 | 0.491 | 91 | 8.5140568 | -2.2537111 | 0.519 |
| 92 | 11.359 | -3.3512 | 0.038 | 92 | 10.375 | 8.9267 | 0.046 | 92 | 8.3812547 | -1.7517043 | 0.020 |
| 93 | 11.342 | -3.3856 | 0.225 | 93 | 10.329 | 8.9236 | 0.081 | 93 | 8.3753939 | -1.7708932 | 0.118 |
| 94 | 11.227 | -3.1922 | 0.026 | 94 | 10.307 | 9.0012 | 0.075 | 94 | 8.2997474 | -1.6802471 | 0.014 |
| 95 | 11.209 | -3.2112 | 0.044 | 95 | 10.233 | 9.0109 | 0.064 | 95 | 8.2919278 | -1.6915956 | 0.023 |
| 96 | 11.252 | -3.2178 | 0.048 | 96 | 10.297 | 9.0128 | 0.027 | 96 | 8.3148204 | -1.6915197 | 0.025 |
| 97 | 11.209 | -3.1955 | 0.583 | 97 | 10.314 | 8.9912 | 0.303 | 97 | 8.2906497 | -1.6834242 | 0.308 |
| 98 | 11.163 | -2.6144 | | 98 | 10.083 | 9.1866 | | 98 | 8.2235494 | -1.3830953 | |
| MAX DELTA | | 2.971 | | | | 1.383 | | | | | 1.560 |

FIG. 4

**RELATIVE CHANGE IN OUTPUT IMPEDANCE VERSUS AGC STEP**

MEASURED DATA ORIGINAL BASELINE — · —
MEASURED DATA WITH 30 OHM SHUNT RESISTOR — ■ —
PREDICTED DATA WITH 30 OHM SHUNT RESISTOR ····▲····

DEVIATION

AGC STEP

FIG. 5

m7
IN DEP (m7) = 75.000
S11_PREDICTED_DATA_WITH_30_OHM_SHUNT_RESISTOR 1=0.709/-172.836
IMPEDANCE = 8.543-j3.039

m2
INDEP(m2)=75.000
S11_MEASURED_DATA_WITH_30_OHM_SHUNT_RESISTOR=0.648/161.048
IMPEDANCE=10.969+j7.954

m1
INDEP(m1)=75.000
S11_MEASURED_ORIGINAL_DATA_WITHOUT_SHUNT_RESISTOR=0.640/-166.040
IMPEDANCE= 11.119-j5.823

S11_PREDICTED_DATA_WIH_30_OHM_SHUNT_RESISTOR1
S11_MEASURED_DATA_WITH_30_OHM_SHUNT_RESISTOR
S11_MEASURED_ORIGINAL_DATA_WITHOUT_SHUNT_RESISTOR

60

m2

m7  m1

AGC(60.000 TO 98.000)

FIG. 6

FIG. 7

AMPLIFIER
OUTPUT

C
C1
C=68 pF
81

84

R
R2
R=820 OHM

82

R
R1
R=6.8 OHM

R
R3
R=820 OHM

83

80

SAW
INPUT

RESITIVE NETWORK

FIG. **8**

AMPLIFIER
OUTPUT

C
C8
C=33 pF   92

91

R
R2
R=30 OHM

93

C
C9
C=47 PF   94

90

L6
L=3 OHM
R=

SAW
INPUT

FIG. **9**

100

101                                                          103

AMPLIFIER                                                         SAW
OUTPUT                                                            INPUT

C                                                           C
C1                                                          C2
C=47 pF                                                     C=1.8 pF

                              R
                              R1
                102           R=100 OHM

FIG. 10

FIG. 11

FIG. 12

FIG. 13

EP 2 670 049 A1

Europäisches
Patentamt

European
Patent Office

Office européen
des brevets

**EUROPEAN SEARCH REPORT**

Application Number

EP 12 17 0263

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2005/022740 A2 (NOKIA CORP [FI]; NOKIA INC [US]; KALAJO SAMI [US]; JARVINEN ESKO [US];) 10 March 2005 (2005-03-10) * page 6, line 12 - page 13, line 15; figures 2,5A,5B,8 * | 1-15 | INV. H03F3/24 H03F3/189 H03F1/56 H04B1/04 H03G3/30 |
| X | WO 2010/010525 A1 (NXP BV [NL]; VILLAIN FREDERIC FRANCOIS [FR]; FERON BENOIT [FR]) 28 January 2010 (2010-01-28) * page 1, line 2 - page 8, line 15; figures 1-16 * | 1-15 | |
| A | RACHOD PATACHAIANAND ET AL: "Performance Comparison of Adaptive Power Control in UMTS", WIRELESS BROADBAND AND ULTRA WIDEBAND COMMUNICATIONS, 2007. AUSWIRELESS 2007. THE 2ND INTERNATIONAL CONFERENCE ON, IEEE, PI, 1 August 2007 (2007-08-01), pages 81-85, XP031132823, ISBN: 978-0-7695-2842-7 * page 82, left-hand column, line 36 - right-hand column, line 28; figure 1 * | 10,11 | |

| | | | TECHNICAL FIELDS SEARCHED (IPC) |
|---|---|---|---|
| | | | H03F H04B H03G H04W H03H |

The present search report has been drawn up for all claims

| Place of search | Date of completion of the search | Examiner |
|---|---|---|
| The Hague | 26 October 2012 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                    EP 12 17 0263

This annex lists the patent family members relating to the patent documents cited in the above-mentioned European search report.
The members are as contained in the European Patent Office EDP file on
The European Patent Office is in no way liable for these particulars which are merely given for the purpose of information.

26-10-2012

| Patent document cited in search report | | Publication date | Patent family member(s) | | Publication date |
|---|---|---|---|---|---|
| WO 2005022740 | A2 | 10-03-2005 | CN | 1871745 A | 29-11-2006 |
| | | | EP | 1665519 A2 | 07-06-2006 |
| | | | KR | 20060069481 A | 21-06-2006 |
| | | | US | 2005059362 A1 | 17-03-2005 |
| | | | WO | 2005022740 A2 | 10-03-2005 |
| WO 2010010525 | A1 | 28-01-2010 | CN | 102100000 A | 15-06-2011 |
| | | | EP | 2308170 A1 | 13-04-2011 |
| | | | US | 2011130104 A1 | 02-06-2011 |
| | | | WO | 2010010525 A1 | 28-01-2010 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

•   *3GPP TS 34.121 V6.0.0,* March 2005